# EUROPEAN PATENT APPLICATION

(11) **EP 0 782 189 A2**
(43) Date of publication of application: **02.07.1997**
(21) Application number: 96308689.7
(22) Date of filing: 02.12.1996
(51) Int. Cl.: H01L 23/532

(54) **Aluminium alloy for on-chip wiring applications**

(30) Priority: 29.12.1995 US 9388; 14.03.1996 US 616018
(71) Applicant: International Business Machines Corporation, Armonk, N.Y. 10504 (US)
(72) Inventor: Ronay, Maria, Briarcliff Manor, New York 10510 (US)
(74) Representative: Waldner, Philip

(57) **Abstract**

An integrated circuit chip interconnect wiring level and method of making is described incorporating an adhesion layer M of Ti, Zr, Hf, V, Nb, Ta, W and alloys thereof and a layer of Al-rare-earth or Al-Y alloy. The layers may be heat treated to become one layer. A further layer of AlCu, AlCuSi or AlCuGe alloy may be added and heat treated to form one layer with the layers below. The problems of polishing MAl3 or other M aluminides by reducing their formation, of scratching by reducing the size of the polishing debris, and of Cu plate out during polishing are overcome.

## Description

This invention relates to aluminium alloy for semiconductor integrated circuit chip wiring applications and, more particularly to interconnection wiring on the chips where several levels of wiring are required.

The patterning of SiO2 or other dielectric to form trenches etc., followed by a conformal metal deposition to fill the trenches, and subsequent planarization of the metal by chemical-mechanical polishing, to remove the metal outside of the trenches is called the Damascene process. In the Damascene process the conductor fills in the trenches or recesses produced in the patterned dielectric, but is perfectly removed from the surface of the dielectric features. The Damascene process is used to produce lines and vias for on-chip wiring applications. An alternate on-chip wiring process, in which the conductor metal is patterned, most often by reactive ion etching (RIE), followed by the conformal deposition of the dielectric, and the planarization of the dielectric by chemical-mechanical polishing, is significantly more expensive, restricts the quantity of alloying elements to be used and suffers from alignment problems.

The metallurgy currently used for the Damascene process is the same as the one used for the alternate RIE process consisting for example of 200 Angstroms titanium liner, 2500 Angstroms Al-1 wt. % Si-0.5 wt. % Cu alloy deposited cold, and 5000 Angstroms Al-0.5 wt. % Cu alloy deposited at around 500 degrees C. Here the aluminium alloy averages only 0.33 % eutectic-forming silicon. The titanium forms extremely hard large-grained TiAl3 during the high temperature deposition causing cracks at the sidewalls of conductor lines. Its removal from large areas of dielectric by polishing takes a long time causing a severe overpolish of the top of the conductor lines which may be of soft aluminium alloy resulting in high sheet resistance of the conductor.

A further problem is that the copper of the aluminium alloy goes into solution into the polishing slurry during polishing, and, subsequently, when the titanium-rich interfacial layer is reached by polishing, this copper plates out of the slurry solution. The plating out of copper results in shorts between wires via the dielectric surface.

It is an object of the embodiment of the invention that the Damascene process be made viable by an aluminium alloy and metal combination which does not have the above problems.

It is a further such object to provide a metal alloy and metal combination that promotes polishability, a new notion introduced in this invention.

It is a further such object to provide a metal alloy and metal combination that improves form filling of trenches or recesses and vias.

In accordance with an aspect of the invention, an apparatus and method for conducting electricity is described comprising a dielectric substrate having recesses therein, a layer of material selected from the group consisting of Ti, Zr, Hf, V, Nb, Ta, W and alloys thereof formed on the bottom and sidewalls of a recesses which functions to provide adhesion and promotes wetting, a layer of an Al-rare earth or yttrium alloy formed over the layer of material, the rare earth or yttrium in the range from 0.02 to 5 atomic percent, and a layer of AlCu or Al-Cu-Si or Al-Cu-Ge alloy formed over the layer of Al-rare earth or yttrium alloy, the layer of AlCu alloy or Al-Cu-Si or Al-Cu-Ge filling the recesses in the dielectric layer, where none of the alloying elements is over five (5) atomic percent. The invention may further include an Al-M-rare earth or Al-M-Y ternary compound dispersoids in at least one of the layers where M is selected from the group consisting of Ti, Zr, Hf, V, Nb, Ta, W and alloys thereof.

There is further provided a two layer structure resistant to the formation of MAl3 therein where M is selected from the group consisting of Ti, Zr, Hf, V, Nb, Ta, W and alloys thereof comprising a first layer of M on a substrate, and a second layer of eutectic phase alloy formed over the first layer, the eutectic phase alloy including Al and one or more elements selected from the group consisting of Y, Gd, Dy, Ho, Er and Sm.

There is further provided a method for reducing the formation of MA13 in an Al alloy layer in physical contact with a layer M where M is selected from the group consisting of Ti, Zr, Hf, V, Nb, Ta, W and alloys thereof comprising the steps of forming the M layer on a substrate, selecting a eutectic phase alloy from Al and one or more elements selected from the group consisting of Y, Gd, Dy, Ho, Er and Sm and forming a layer of the eutectic alloy over the M layer. The invention may further include the step of heat treating the layers to form spherical dispersoids of Al-M-Rare earth within the eutectic alloy layer.

There is further included a conductor for multilayer wiring on a semiconductor chip comprising a metal composed of AlR, AlGeR or AlSiR where R is a rare earth or yttrium, the metal having first regions selected from the group consisting of Al and alloys thereof, the metal having second regions of AlnR compounds, Ge or Si dispersed in the first region by R, the first and second regions having an interfacial energy of about eutectic interfacial energy whereby debris formed by polishing the metal is enhanced by the low interfacial energy and the debris size is determined by the distance of the second regions.

These and other features, objects, and advantages of at least the embodiment of the present invention will become apparent upon consideration of the following detailed description of the invention when read in conjunction with the drawing in which:
Fig. 1 is a cross section view of a first embodiment of the invention.
Fig. 2 is a cross section view of a second embodiment of the invention.
Fig. 3 is a cross section view of a third embodiment of the invention.
Fig. 4 is an Al-Gd phase diagram.
Fig. 5 is a cross section view of a damascene wiring level of the prior art prior to polishing.
Fig. 6 is a cross section view of a damascene wiring level of the prior art after polishing.

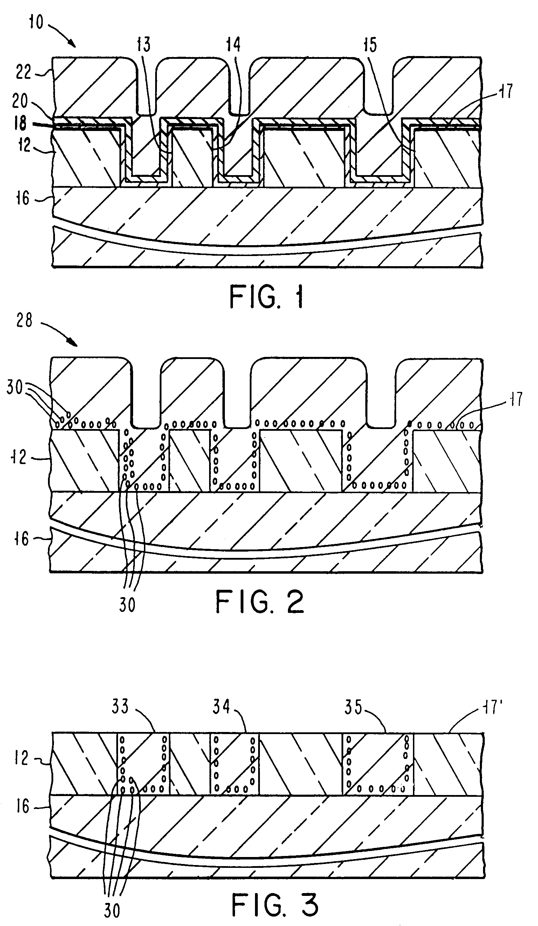

Referring now to the drawing, Fig. 1 shows conductor structure 10 formed over a dielectric 12 which may be patterned to have recesses 13-15. Dielectric 12 may be for example silicon dioxide, silicon nitride, polyimide, or diamond-like carbon. Dielectric 12 may be spun-on or deposited over substrate 16 which may be a lower level of wiring of dielectric and conductors embedded therein or a semiconductor, such as silicon, containing semiconductor devices and contacts (not shown).

Conductor structure 10 has a first layer 18 which may function as an adhesion layer, wetting layer and/or diffusion barrier also called a liner. First layer 18 may be of a metal selected from the group consisting of Ti, Zr, Hf, V, Nb, Ta, W and alloys thereof. First layer 18 may have a thickness in the range from about 100 to 400 Angstroms and formed by sputtering, collimated sputtering or any other suitable means. Subsequent to forming first layer 18, a second layer 20 is formed such as by sputtering or any other suitable means at room temperature or at a colder temperature. Second layer 20 formed on first layer 18 may be an aluminium-rare earth alloy, preferably an aluminium-gadolinium alloy, or any other aluminium-rare earth alloy or an Aluminium yttrium alloy. Other suitable rare earth elements besides Gd may be for example Dy, Ho, Er, and Sm which are given in Table I.

**Table I**

| Concentration of aluminium-rich eutectic |
|---|
| Gd.....5.0 at. %.....23.0 wt. % |
| Dy.....2.5 at. %.....13.4 wt. % |
| Ho.....1.8 at. %.....10.0 wt. % |
| Er.....1.0 at. %......6.0 wt. % |
| Sm.....3.0 at. %.....15.0 wt. % |
| Si....12.2 at. %.....12.6 wt. % |
| Ge....28.4 at. %.....51.6 wt. % |

Second layer 20 of Al-rare earth or Al-Y may and preferably has the composition of the eutectic as given in Table I, or the rare-earth or Y content in second layer 20 should be less than the eutectic composition.

A third layer 22 is formed over second layer 20 with a sufficient thickness to fill completely recesses or trenches 13-15 up to or above the level of the top surface of dielectric 12. Third layer 22 may be formed or deposited at high temperature for example in the range from about 350 degrees C to 550 degrees C. Third layer may be any aluminium alloy, preferably an Al-Cu alloy, or an Al-Si-Cu alloy, or an Al-Ge-Cu alloy where the amount of any one element in the alloy does not exceed 5 atomic percent.

Referring to Fig. 2, conductor structure 28 is shown. Conductor structure 28 is significant because the formation of MAl3 where M may be selected from the group consisting of Ti, Zr, Hf, V, Nb, Ta, and W, is reduced by the presence of the rare-earth element. If an aluminium-rare-earth alloy or aluminium-yttrium, preferably aluminium gadolinium alloy is deposited cold as second layer 20 on top of first layer 18, an Al-M-rare-earth or Al-M-Y ternary compound dispersoids 30 form instead of MA13 from elements of the first and second layer. For example, if first layer 18 is Ti and the rare-earth in second layer 20 is Gd, then Al-Ti-Gd ternary compound dispersoids will form instead of TiAl3, The ternary compound dispersoids 30 are not as hard as TiAl3, therefore former layers 18 and 20 now part of conductor structure 28 do not cause cracking on the sidewalls and since the removal of ternary compound dispersoids 30 by polishing from the bottom of the fields (areas of dielectric) is much easier, the overpolish of the aluminium-alloy conductor lines 33-35 is reduced or eliminated as shown in Fig. 3. Further, since the conductor lines 33-35 are not overpolished, the sheet resistance of conductor lines 33-35 is also reduced. It is important to note that the electrical current will percolate around the dispersoid therefore the loss of conductivity will be significant compared to that due to a continuous layer of TiAl3.

In Figs. 2 and 3, like references are used for functions corresponding to the apparatus of Figs. 1 or 2.

Since rare-earth or Y atoms are very electronegative, copper from alloy if used for layer 22 is not going into the slurry solution during polishing, but the rare-earth or Y does go into the slurry solution instead. The rare earth or Y atoms provide sacrificial corrosion protection with respect to Cu. If Cu does not go into the slurry solution during polishing, then Cu is not available to plate out of the slurry solution. The rare-earth or Y may come from an aluminium-rare-earth or aluminium-yttrium alloy of layer 20 or from an aluminium-M-rare-earth or aluminium-M-yttrium ternary compound dispersoids where M is selected from the group consisting of Ti, Zr, Hf, V, Nb, Ta, W and alloys thereof.

Fig. 3 shows conductor lines in recesses 13-15 formed by polishing the excess conductor structure 28 from over dielectric upper surface 17'. Dielectric surface 17 may have been lowered a little by polishing resulting in a new surface 17'.

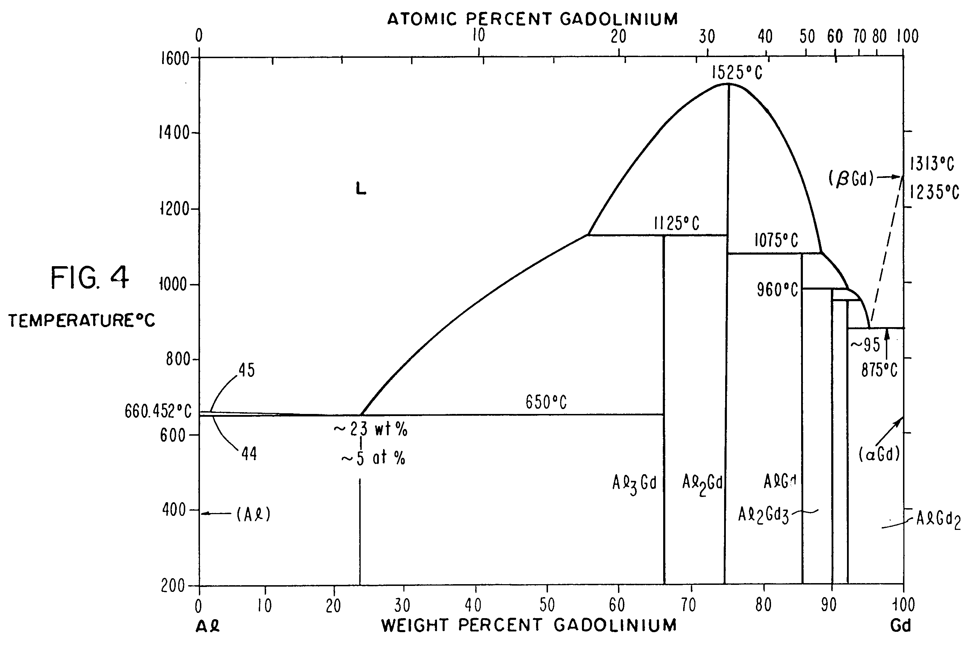

Fig. 4 is an Al-Gd phase diagram. In Fig. 4 the ordinate represents temperature in degrees C and the abscissa represents weight percent gadolinium. Fig. 4 shows that the eutectic is at 5 atomic percent Gd or at 23 weight percent Gd. As shown in Fig. 4, even at smaller concentrations of Gd i.e. less than 5 atomic percent, the temperature range of solidification is at most 10 degrees C. Thus, the condition for good alloy flow can be fulfilled at small atomic percent alloying element in layer 20. To achieve such a small temperature range of solidification, much larger atomic percentage is needed in the case of Si or Ge alloying elements as shown in Table I. In Fig. 4 the temperature range is the space between curves or lines 44 and 45. Yttrium also has a similar phase diagram.

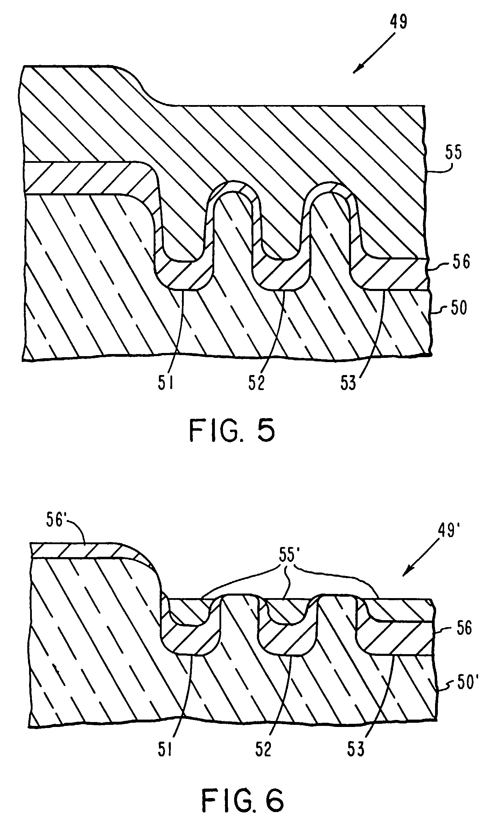

Fig. 5 shows a wiring level 49 on a patterned dielectric of the prior art before polishing. In Fig. 5, dielectric layer 50 has been patterned having recesses 51-53. A liner deposited on dielectric layer 50 has reacted with an Al alloy layer 55 deposited thereover with the liner forming layer 56 of TiAl3 which is about three times thicker than the liner layer was. Some liner not shown may remain between dielectric layer 50 and layer 56.

Fig. 6 shows wiring level 49' on a patterned dielectric layer 50 after polishing. Layer 56 where exposed to polishing has been thinned to be 56' but which withstood the polishing. Dielectric layer 50 where patterned has been polished or dished down between recesses 51-53 to be layer 50'. Al alloy layer 55 has been substantially polished and has been thinned down to be 55' due to the reduced height of dielectric 50' in the region of recesses 51- 53. This was necessitated by the need to remove the hard TiAl3 56' from the fields. With less cross section area of Al alloy 55' in recesses 51-53, the resistivity of the conductors will be increased. Another problem is that the remaining conductor cross-section is further reduced by the TiAl3 layer which has a resistivity of about 70 micro ohm cm. In Fig. 6 like references are used for functions corresponding to the apparatus of Fig. 5.

In the damascene process, a chemical mechanical polishing process is needed to create a near-perfect surface with high dimensional and geometrical accuracy, referred to as planarization, and the absence of defects, most importantly scratches in the metal surface which may cause shorts and which carry their imprints on to higher levels of metallization. Aluminium and alloys such as AlCu are difficult metals to polish, because the metal itself is soft, but the natural oxide, that forms on its surface, is an extremely hard compound, which by itself is a well-known abrasive. No matter how gentle an abrasive is initially applied in an aluminium polishing slurry, the aluminium particles which are removed from the workpiece surface of the integrated circuit in the course of polishing become oxidized. The oxidized aluminium particles create an abrasive in the slurry and produce scratches on the workpiece surface.

The aluminium, that is coming off the polishing surface during polishing, shall be referred to as the "polishing debris". In my work, it has been observed in the course of polishing unpatterned as well as patterned aluminium films, where the pattern dimensions varied between 200 micrometers and 0.25 micrometers, that blanket films have the highest density of scratches, while in patterned films, the narrower the aluminium lines, and the farther away these lines are from large fields of aluminium, the smaller the density of scratches becomes. The cause of this phenomenon is that in patterned films the aluminium line surfaces alternate with Si02 surfaces, thus the aluminium particles that are removed by polishing, break up to smaller pieces, than during the polishing of large aluminium fields, and these smaller particles upon oxidation represent smaller abrasive particles and thus create smaller scratches. The scratch-free polishing of large aluminium lines however cannot depend on the layout of the design of the integrated circuit chip alone, because the integrated circuit chip needs to have large areas of continuous aluminium surfaces for pads, moreover, even if the chip would only consist of 0.25 micrometer aluminium lines, the scratch-causing polishing debris is still too large, and it's particle size is only restricted in two dimensions, width and depth. The smaller the particles that come off during polishing (polishing debris), the higher the quality of the polished surface. In order to break down the polishing debris to smaller sizes in all three dimensions i.e. width, depth, and length, the aluminium or alloys thereof such as AlCu has to be alloyed in a way that it contains a second phase, that is finely dispersed, and has a low interfacial energy with aluminium. In the course of polishing, the aluminium or alloy thereof that is removed, fractures along the low-energy interfaces with the second phase, so that the distance between second-phase particles and hence the distance between low-energy interfaces determines the size of the polishing debris, and thus the quality of the polished surface.

The phase diagram between two elements that do not form a solution in the solid state is characterized by a eutectic, which occurs at a given composition and at a given temperature, because here the system consists of two solid and one liquid phases and thus exhibits no degree of freedom, i.e. neither the composition nor the temperature can change during solidification. The two solid phases crystallize alternately from the melt, forming lamellae, rods, or spherical particles. The melt solidifies at a single temperature, same as an element, which is very advantageous for form filling of recesses in dielectric. For polishability, the most important characteristic of a solid eutectic is that the interfacial energy between the two solid phases is the lowest amongst all interfacial energies and is typically 1/3 to 1/4 of the grain boundary energy of the elements that form it. Such low interfacial energy assures that in the course of polishing the polishing debris breaks down to a size approximating the distance between eutectic interfaces.

For Damascene polishing one has to look for alloying elements that form a eutectic with aluminium at a low concentration, because a large atomic percent of alloying elements would cause device problems. One problem may be higher resistivity of the alloy forming the conductors or chip wiring level. Silicon and germanium form a eutectic with aluminium at very high percentages, 12.2 and 28.4 atomic percent respectively. Therefore, too much of these alloying elements (Si or Ge) would have to be added to aluminium in order to have a sufficient amount of the eutectic phase which would be everywhere because the alloying element diffuses. Rare earth elements however form a eutectic with aluminium at much lower atomic percents as shown in Table I. For example, Al - Gd forms a eutectic at 5 at .% Gd. In this eutectic Al and Al3Gd phases alternate in the alloy. Their interface is the low energy eutectic interface which breaks down during polishing reducing the polishing debris. While all rare earth elements (Atomic Numbers 57-71) behave similarly with respect to alloying with aluminium, those rare earth elements given in Table I are preferred partially because they are the least reactive with the ambient and partially because of cost considerations in purchasing and using them. Table I shows that Gd, Dy, Ho, Er, and Sm form a eutectic with aluminium between 5 and 1 atomic percent.

Under form-filling in microelectronic applications, we mean the ability to fill trenches of high aspect ratios with the metal at ambient or elevated temperatures. Form-filling depends on the fluidity of the alloy and on the qualities of the interface that has to be contacted in the course of form-filling. Fluidity is the characteristic of a molten alloy that enables mold filling. The properties that influence fluidity are viscosity, surface tension, and the manner in which the particular alloy solidifies. The viscosity of molten aluminium is very low and is not strongly influenced by alloying. Surface tension is not altered by copper, silicon and germanium alloying. Rare earths are reducing the surface tension of molten aluminium by about 10 percent per 1 weight percent alloying element, which is favorable for form filling.

While a low viscosity and a low surface tension of molten aluminium are favorable for form filling, none of these properties are as important as the temperature range of solidification. Fluidity is inversely proportional to the temperature range of solidification, that is, fluidity is highest for pure metals and eutectic alloys, and lowest for solid solution alloys.

While there has been described and illustrated a wiring level in an integrated circuit chip containing an adhesion layer, a layer of Al-rare-earth alloy for example AlGd or AlY alloy, and a layer of AlCu, or Al-Cu-Si or Al-Cu-Ge which may then be specifically heat treated or heat treated in the course of the high temperature reflow to form dispersoids on an element from the adhesion layer and the rare earth, it will be apparent to those skilled in the art that modifications and variations are possible with out deviating from the broad scope of the invention which shall be limited solely by the scope of the claims appended hereto.

In summary therefore, there is described an integrated circuit chip interconnect wiring level and method of making is described incorporating an adhesion layer M of Ti, Zr, Hf, V, Nb, Ta, W and alloys thereof and a layer of Al-rare-earth or Al-Y alloy. The layers may be heat treated to become one layer. A further layer of AlCu, AlCuSi or AlCuGe alloy may be added and heat treated to form one layer with the layers below. The problems of polishing MAl3 or other M aluminides by reducing their formation, of scratching by reducing the size of the polishing debris, and of Cu plate out during polishing are overcome.

## Claims

1. A structure (10) for conducting electricity comprising:
a dielectric substrate (12) having recesses (13-15) therein, said recesses (13-15) having a bottom and sidewalls;
a first layer (18) of material selected from the group consisting of Ti, Zr, Hf, V, Nb, Ta, W and alloys thereof formed on the bottom and sidewalls of said recesses (13-15), said material functions to provide adhesion to said bottom and sidewalls, characterised by;
a second layer (20) selected from the group consisting of Al-rare earth alloy and Al-Y alloy formed over said first layer (18) of material, said rare earth in said Al-rare earth alloy being in the range from 0.02 to 5 atomic percent and said Y in said Al-Y alloy being in the range from 0.02 to 5 atomic percent.

2. The structure of claim 1 further including a third layer (22) of material formed over said second layer (18), said material selected from the group consisting of Al, AlCu alloy, Al-Cu-Ge alloy, and Al-Cu-Si alloy.

3. The structure of claim 2 wherein said third layer (22) substantially fills said recesses (13-15) in said dielectric layer (12).

4. The structure of claims 2 or 3 wherein said third layer (22) material constituents other than Al are each less than 5 atomic percent.

5. The structure of any of the preceding claims further including dispersoids selected from the group consisting of Al-M-rare earth ternary compound and Al-M-Y ternary compound in at least one of said first and second layers where M is selected from the group consisting of Ti, Zr, Hf, V, Nb, Ta, W and alloys thereof.

6. The structure of any of the preceding claims wherein said first layer (18) is in the range from about 100 to about 400 Angstroms thick.

7. The structure of any of the preceding claims wherein said first (18) and second (20) layers are raised to a temperature in the range from 350 degrees C to 550 degrees C to form a single layer.

8. The structure of claim 2 wherein said first (18), second (20) and third (22) layers are raised to a temperature in the range from 350 degrees C to 550 degrees C to form a single layer.

9. A structure (10) resistant to the formation of MAl3 therein comprising:
a first layer (18) of M on a substrate where M is selected from the group consisting of Ti, Zr, Hf, V, Nb, Ta, W and alloys thereof, characterised by;
a second layer (20) of eutectic phase alloy formed over said first layer (18);
said eutectic phase alloy including Al and one or more elements selected from the group consisting of Y, Gd, Dy, Ho, Er and Sm.

10. A method for reducing the formation of MAl3 in an Al alloy layer (20) in physical contact with a layer (18) of M comprising the steps of:
forming said M layer (18) on a substrate where M is selected from the group consisting of Ti, Zr, Hf, V, Nb, Ta, W and alloys thereof, characterised by;
selecting an eutectic phase alloy from Al and one or more elements selected from the group consisting of Y, Gd, Dy, Ho, Er and Sm, and
forming a layer (20) of said eutectic alloy over said M layer (18).

11. The method of claim 10 wherein said step of forming a layer (20) of said eutectic alloy includes sputtering at or below 23 C degrees.

12. The method of claims 10 or 11 wherein said step of selecting a eutectic phase alloy includes selecting AlGd alloy.

13. The method of claims 10, 11 or 12 further including the step of heat treating said layers to form spherical dispersoids of AlMGd within said eutectic alloy layer.

14. The method of claim 13 where said step of heat treating includes the step of raising the temperature in the range from 350 degrees C to 550 degrees C.

15. The conductor for multilayer wiring on a semiconductor chip comprising:
an alloy selected from the group consisting of Al-R where R is a rare earth and Al-Y,
said alloy having two phases, said first phase consisting of Al and said second phase selected from the group consisting of Al3R and Al3 Y, said first and second phases having low interfacial energy equal to the eutectic interfacial energy whereby debris size formed by polishing said alloy is substantially determined by the distance between said low energy phase boundaries.

16. A conductor for multilayer wiring on a semiconductor chip comprising:
a metal selected from the group consisting Al-Ge-R, Al-Si-R, Al-Ge-Y and Al-Si-Y where R is a rare earth, said metal having first regions selected from the group consisting of Al and alloys thereof,
said metal having second regions of an element selected from the group consisting of Ge and Si, said second regions dispersed in said first region by one of said R and Y, said first and second regions having an interfacial energy substantially equal to the eutectic interfacial energy whereby debris formed by polishing said metal is enhanced by said eutectic interfacial energy and the debris size is substantially determined by the size of said second regions.

17. A method for preventing the plate out of Cu onto a workpiece during polishing with a polishing slurry wherein said workpiece surface includes an Al alloy containing copper comprising the steps of:
selecting an element from the group consisting of one or more rare earth elements, atomic numbers 57-71 and Y, and
introducing one or more said elements onto a surface exposed to polishing whereby said one or more said elements enters the polishing slurry as a sacrificial element in place of Cu.

18. The method of claim 17 wherein said step of introducing includes the step of forming an alloy including one or more said elements having an exposed surface for polishing at times said workpiece is polished.
